# EUROPÄISCHE PATENTSCHRIFT

(11) **EP 1 639 639 B1**
(45) Veröffentlichungstag und Bekanntmachung des Hinweises auf die Patenterteilung: **29.08.2007**
(21) Anmeldenummer: 04733244.0
(22) Anmeldetag: 15.05.2004
(51) Int. Cl.: H01L 23/31, G01J 5/12

(54) **OPTISCHE SENSORANORDNUNG UND ENTSPRECHENDES HERSTELLUNGSVERFAHREN**
OPTICAL SENSOR ARRAY AND METHOD FOR PRODUCING THE SAME
DISPOSITIF DETECTEUR OPTIQUE ET PROCEDE DE PRODUCTION CORRESPONDANT

(30) Priorität: 20.06.2003 DE 10327694
(43) Veröffentlichungstag der Anmeldung: 29.03.2006
(73) Patentinhaber: ROBERT BOSCH GMBH, 70442 Stuttgart (DE)
(72) Erfinder: LUDWIG, Ronny, 72770 Reutlingen (DE); HAAG, Frieder, 72827 Wannweil (DE)
(86) Internationale Anmeldenummer: PCT/DE2004/001027
(87) Internationale Veröffentlichungsnummer: WO 2004/114403

(56) Entgegenhaltungen:
- EP-A- 1 211 721
- WO-A-03/067657
- US-A1- 2002 139 410

## Beschreibung

### STAND DER TECHNIK

Die vorliegende Erfindung betrifft eine optische Sensoranordnung und ein entsprechendes Herstellungsverfahren.

Obwohl auf beliebige optische Sensoranordnungen anwendbar, werden die vorliegende Erfindung sowie die ihr zugrundeliegende Problematik in bezug auf eine Thermopile-Sensoranordnung erläutert.

Thermopile-Sensoren gehören zur Gruppe der thermischen Strahlungssensoren, dass heißt eine einfallende Strahlung führt zu einer Temperaturdifferenz zwischen einer Empfängerfläche und einem Differenzbereich (Wärmesenke). Diese Temperaturdifferenz wird mit Thermoelementen aufgrund des Seebeck-Effektes in eine elektrische Spannung gewandelt. Die Ausgangsspannung ist nicht von den geometrischen Abmessungen der Thermoelemente, sondern lediglich von der gewählten Materialkombination abhängig. Durch Reihenschaltung mehrer gleichbestrahlter Thermoelemente wird die Ausgangsspannung der so realisierten Thermopile's erhöht.

Mit den Technologien der Mikromechanik ist es möglich, die Thermopiles als Siliziumchips analog zu den klassischen Halbleiterbauelementen unter Verwendung der typischen Halbleiterprozesse herzustellen. Die Anwendungen von mehrebenen Technologien erlaubt zusätzlich eine weitere Reduzierung der geometrischen Abmessungen der Thermopiles. Die Thermopiles werden dabei zur Realisierung einer maximalen Empfindlichkeit auf einer möglichst freistehenden thermisch isolierenden Membran vorgesehen. Ein geätzter Siliziumrahmen dient als Träger der Membran und zugleich als thermisches Referenzmedium.

Herkömmliche mikromechanische Thermopile-Sensoren, z.B. mit Infrarotfilter zur Gas-Detektion, werden in TO05-oder TO08-Packages mit optischen Fenstern verbaut. Dabei sitzt das Thermopile-Element mit seiner optisch inaktiven Seite auf den Gehäuseboden, während die Filter in der TO-Kappe verklebt sind. Durch die Wahl des Filtermediums bzw. des Fenstermaterials können während der Konfektionierung der Sensoren in derartigen Metall-Hermetikgehäusen wesentliche Sensoreigenschaften wie Empfindlichkeit, Zeitkonstante und erfasster Spektralbereich beeinflusst werden.

Diese Art des Gehäuses ist sehr teuer und durch die notwendigen Öffnungen in der Kappe auch nicht mehr hermetisch dicht. Es erfolgt in der Regel keine Passivierung der Bonddrähte, was die Tauglichkeit für Anwendungen im Freien, insbesondere Automobilanwendungen, wegen Betauung, Korrosion, etc. in Frage stellt.

Weiterhin bekannt sind vollständig umspritzte beziehungsweise gemoldete Sensoren, zum Beispiel mikromechanische Beschleunigungssensoren. Hierbei wird das Sensorelement mit seiner inaktiven Rückseite auf einen Trägerstreifen (Leadframe) befestigt (geklebt oder gelötet). Mit Drahtbondverbindungen wird ein elektrischer Kontakt auf dafür vorgesehenen Kontaktflächen (sog. Leads) am Rande der Chipmontagefläche hergestellt. Danach wird der Leadframe mit Kunststoffmasse beziehungsweise Mold-Compound umspritzt beziehungsweise gemoldet. Da das Mold-Compound im interessanten Frequenzbereich für Thermopile-Sensoren zur Gas-Detektion (beispielsweise im Infrarotbereich ≥ 4000 nm Wellenlänge) nicht ausreichend transparent ist, wäre bei einer derartigen Montagetechnik (vollständiges Umspritzen) für Thermopile-Sensoren kein optischer Zugang zum Sensor mehr vorhanden.

Schliesslich sind allgemein IC-Gehäuse mit einem an der Rückseite freiliegenden (sog. exposed) Chipmontagebereich (sog. Die-Pad) für Leistungs-IC's zum Zwecke der besseren Wärmeableitung bekannt.

Aus der EP 1 211 721 A1 sind ein verbessertes Gehäuse für ein elektronisches Bauelement sowie die dazu gehörige Fertigungsmethode bekannt. Dabei handelt es sich um ein schützendes Gehäuse aus Plastik für eine in einen Halbleiter integrierte elektronische Schaltung, welche ein elektronisches Bauelement, das von außerhalb aktiviert wird, sowie eine integrierte Steuerschaltung aufweist.

Aus der US 2002/0139410 A1 ist ein Strahlungssensor bekannt. Dieser umfasst einen Thermopile zur Detektion der einfallenden Energie. Der Thermopile und ein Stützelement für den Thermopile werden dabei als integriertes Bauelement hergestellt und bilden einen Trägerchip. Auf den Trägerchip wird ein passender Kappenchip aufgesetzt, so dass der Thermopile sich dadurch in einer Kavität befindet. Der Sensor hat eine Öffnung, welche den Strahlungseinfall in die Kavität erlaubt, so dass die einfallende Strahlungsenergie auf eine zentrale Absorberfläche des Thermopiles trifft.

Aus der nicht vorveröffentlichten WO 03/067657 A2 ist ein elektronisches Halbleiterbauteil bekannt. Dieses weist einen Halbleiterchip auf, welcher eine aktive Chipfläche umfasst, welche von einem erhabenen Metallrahmen eingefasst ist. Ein Kunststoffgehäuse weist eine Aussparung für die aktive Chipfläche innerhalb des Metallrahmens auf und lässt diese frei.

### VORTEILE DER ERFINDUNG

Die erfindungsgemässe optische Sensoranordnung mit den Merkmalen des Anspruchs 1 und das entsprechende Herstellungsverfahren gemäss Anspruch 15 (für die benannten Vertragsstaaten SE, FR und IT) bzw, 14 (für den benannten Vertragsstaat DE) weisen gegenüber den bekannten Lösungsansätzen den Vorteil auf, dass sie eine einfache und sehr kostengünstige Montage, wobei alle Bondverbindungen passiviert sind, ermöglicht. Somit ergibt sich ein für Automobilanwendungen tauglicher Sensor.

Die der vorliegenden Erfindung zu Grunde liegende Idee besteht darin, eine Verpackungseinrichtung, beispielsweise in Form eines moldbaren Gehäuses, mit einem optisch offenen Bereich in Form eines Fensters auf der Chipmontagefläche vorzusehen, in dem ein optischer Sensor vorgesehen ist, der im wesentlichen nur durch das Fenster zu detektierender optischer Strahlung ausgesetzt ist.

Im Vergleich zu einen bekannten Package mit einer Kavität an der Oberseite, bei dem die Montagetoleranzen im Aufbau sehr groß sein können und ein Stempel die aktive Chipfläche vor dem Mold-Compound schützen muss, wird bei der erfindungsgemäßen Sensoranordnung kein Stempel benötigt, der direkt auf den Chip drückt und diesen eventuell beschädigen kann. Lediglich das Fenster im Chipaufnahmebereich muss vor dem Verpackungsmaterial (z.B. Kunststoff, Molding Compound) geschützt werden. Eine Passivierung mit einem nichttransparenten Standard-Mold-Compound ist möglich, so dass kein weiteres Passivierungsmaterial benötigt wird. Im Falle der Montage auf ein Substrat besteht die Möglichkeit der Anbringung weiterer optischer Filter auf dem Substrat oder der Verpackung selbst. Somit lassen sich beispielsweise austauschbare oder nachrüstbare Filter vorsehen.

In den Unteransprüchen finden sich vorteilhafte Weiterbildungen und Verbesserungen des jeweiligen Gegenstandes der Erfindung.

Gemäss einer bevorzugten Weiterbildung weist die Sensorchipanordnung einen ersten Chip mit einer ersten und einer zweiten gegenüberliegenden Oberfläche und einen zweiten Chip mit einer dritten und einer vierten gegenüberliegenden Oberfläche auf, welche über die erste und dritte Oberfläche verbunden sind und einen Hohlraum einschliessen, in dem die Sensorstruktur angeordnet ist; und der erste Chip auf der ersten Oberfläche einen Kontaktbereich für Drahtbonds aufweist, der seitlich über den zweiten Chip vorsteht (Bondbereich) und auf den mindestens ein an ein Anschlusselement (Lead) gebondeter Bonddraht geführt ist.

Gemäss einer weiteren bevorzugten Weiterbildung sind der optisch transparente Bestrahlungsbereich und der umgebende Montagebereich auf der zweiten Oberfläche (Grundfläche) des ersten Chips vorgesehen.

Gemäss einer weiteren bevorzugten Weiterbildung sind der optisch transparent Bestrahlungsbereich und der umgebende Montagebereich auf der vierten Oberfläche des zweiten Chips vorgesehen.

Gemäss einer weiteren bevorzugten Weiterbildung weist der Chipaufnahmebereich (z.B. das Die-Pad eines verwendeten Leadframes) eine fünfte und eine sechste gegenüberliegende Oberfläche auf, wobei die fünfte Oberfläche mit dem Montagebereich verbunden ist.

Gemäss einer weiteren bevorzugten Weiterbildung ist die sechste Oberfläche nicht von der Verpackungeinrichtung bedeckt ist und liegt mit einer Unterseite der Verpackungeinrichtung in einer Ebene.

Gemäss einer weiteren bevorzugten Weiterbildung ragen die Anschlusselementen aus gegenüberliegenden Seitenflächen der Verpackungeinrichtung heraus, wobei ihre Enden (z.B. gemäss der Norm für gemoldete Gehäuse) in der Ebene der Unterseite liegen.

Gemäss einer weiteren bevorzugten Weiterbildung sind die Enden der Anschlusselemente und die sechste Oberfläche mit einem Substrat verbunden (z.B. verklebt oder gelötet), welches ein Durchgangsloch im Bereich des Fensters aufweist.

Gemäss einer weiteren bevorzugten Weiterbildung ist die sechste Oberfläche teilweise von der Verpackungeinrichtung bedeckt ist und eine Unterseite der Verpackungeinrichtung in einer Ebene unterhalb der sechsten Oberfläche liegt.

Gemäss einer weiteren bevorzugten Weiterbildung ist auf der zweiten bzw. vierten Oberfläche des ersten Chips und/oder am Substrat im Bereich des Durchgangslochs eine optische Filtereinrichtung vorgesehen.

### ZEICHNUNGEN

Ausführungsbeispiele der Erfindung ist in den Zeichnungen dargestellt und in der nachfolgenden Beschreibung näher erläutert.

Es zeigen:
- Fig. 1a-d: eine erste Ausführungsform der erfindungsgemässen Sensorvorrichtung und deren Aufbau;
- Fig. 2a,b: eine zweite Ausführungsform der erfindungsgemässen Sensorvorrichtung und deren Aufbau;
- Fig. 3a-d: eine dritte Ausführungsform der erfindungsgemässen Sensorvorrichtung und deren Aufbau; und
- Fig. 4a,b: eine vierte Ausführungsform der erfindungsgemässen Sensorvorrichtung und deren Aufbau.

### BESCHREIBUNG DER AUSFÜHRUNGSBEISPIELE

In den Figuren bezeichnen gleiche Bezugszeichen gleiche oder funktionsgleiche Komponenten.

Ohne Beschränkung der Allgemeinheit beschreiben die nachstehenden Ausführungsformen eine optische Sensoranordnung für einen optischen Thermopile-Sensor für Automobilanwendungen. Insbesondere betreffen die Beispiele einen mikromechanischen optischen Thermopile-Sensor mit integriertem Filter zur Detektion von infraroter Strahlung im Bereich ≥ 4000 nm Wellenlänge zur Gas-Detektion (CO₂-Sensor).

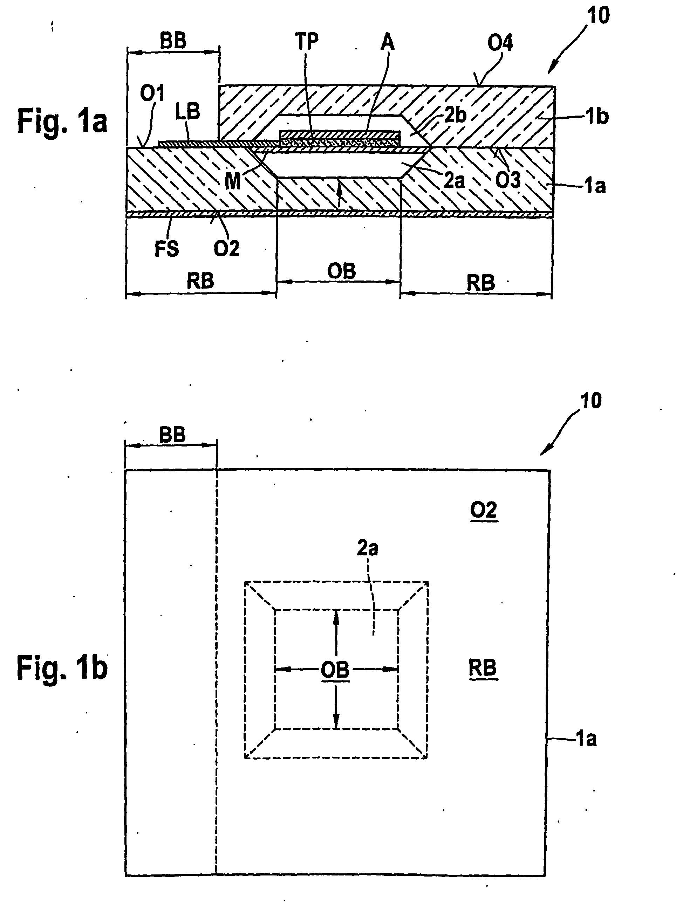

Fig. 1a-d zeigen eine erste Ausführungsform der erfindungsgemässen Sensorvorrichtung und deren Aufbau.

In Figur 1a bezeichnet Bezugszeichen 10 allgemein eine optische Sensoranordnung in Form einer Thermopile-Sensoranordnung. Die Sensoranordnung 10 umfasst einen unteren Chip 1a mit einem Hohlraum 2a, über dem eine Membran M vorgesehen ist. Auf der Membran M aufgebracht sind Thermopile-Sensorelemente TP und eine darüber liegende Absorberschicht A. Über eine Leiterbahn LB ist eine elektrische Verbindung von den Thermopile-Elementen TP in den äußeren Randbereich des ersten Chips 1a geführt, welcher im folgenden auch als Drahtbondbereich BB bezeichnet wird.

Auf die obere Oberfläche O1 des ersten Chips 1a ist ein zweiter Chip 1b mit seiner Oberfläche 03 als Kappe gebondet, wobei der zweite Chip 1b ebenfalls einen Hohlraum 2b aufweist, der zu dem Hohlraum 2a des ersten Chips ausgerichtet ist. Der zweite Chip 1b ist dermaßen bemessen und ausgerichtet, dass er den Drahtbondbereich BB des ersten Chips 1a freilässt. Auf die untere Oberfläche 02 des ersten Chips 1a aufgebracht sind Filterschichten FS zum Ausfiltern bestimmter Wellenlängen.

Zu dieser ersten Ausführungsform sei bemerkt, dass das Silizium des ersten und zweiten Chips 1a, 1b für die zu erfassenden optischen Wellenlängen im mittleren Infrarotbereich ausreichend transparent ist. Bei üblichen Thermopile-Elementen TP wird die zu erfassende optische Strahlung direkt auf die Absorberschicht A gerichtet. Dies würde bei dem Aufbau nach Figur 1a bedeuten, dass die optische Strahlung die obere Oberfläche 04 des zweiten Chips 1b zugerichtet werden müsste.

Im Gegensatz zu dieser üblichen Vorgehensweise ist jedoch bei dieser ersten Ausführungsform der optische Bestrahlungsbereich OB auf der Oberfläche 02 definiert und erstreckt sich aufbaubedingt über den Durchmesser der Absorberschicht A beziehungsweise der darunter liegenden Thermopile-Elemente TP. Untersuchungen haben ergeben, dass die durch diese Bestrahlungsart auftretenden Verluste durch die Thermopile-Elemente TP selbst relativ gering sind und nur wenige Prozent der gesamten Strahlungsausbeute ausmachen.

Ringförmig umgeben ist der zentrale optische Bestrahlungsbereich OB auf der Oberfläche 02 von einem Montagebereich RB, welcher, wie nachstehend ausführlich erläutert, zur Montage dieser Sensoranordnung 10 herangezogen wird, wobei der optische Bestrahlungsbereich freiliegend gelassen wird.

In Figur 1b ist eine Draufsicht auf die Oberfläche 02 des ersten Chips 1a (ohne die Filterschicht FS) gezeigt. Durch die gestrichelten Linien hervorgehoben sind der Hohlraum 2a, der optische Bestrahlungsbereich OB, der Montagebereich RB sowie der auf der gegenüberliegenden Oberfläche O1 liegende Drahtbondbereich BB.

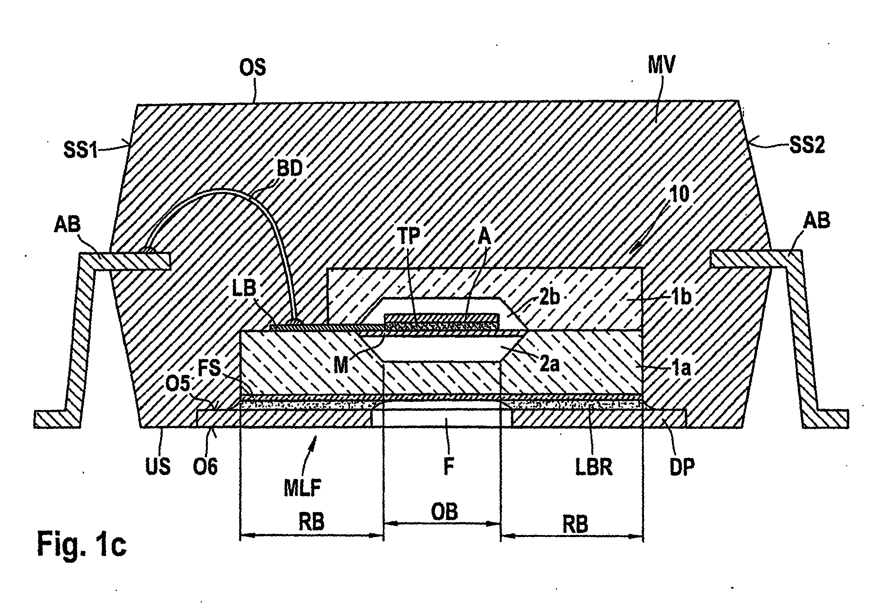

Gemäß Figur 1c wird die Sensoranordnung 10 gemäß Figur 1a,b auf einen Montagerahmen MLF in Form eines üblichen Leadframes mittels eines Montagebereichs LBR geklebt oder gelötet. Der Montagerahmen MLF umfasst dazu einen mit einem Fenster F versehenen Chipaufnahmebereich DP sowie eine Mehrzahl von Anschlusselementen beziehungsweise -beinen AB. In der Schnittsdarstellung von Figur 1c nicht dargestellt ist die Aufhängung des Chipaufnahmebereichs DP an entsprechenden Anschlusselementen - üblicherweise in den Ecken des Montagerahmens MLF.

Bei der Montage der Sensorchipanordnung 10 wird der Montagebereich RB, welcher dem optischen Bestrahlungsbereich OB ringförmig umgibt, mit dem Chipaufnahmebereich DP derart verbunden, dass der optische Bestrahlungsbereich OB nicht vom Chipaufnahmebereich DP bedeckt ist, also durch das Fenster F nach außen hin frei liegt.

Des weiteren werden Anschlusselemente AB über entsprechende Bondrähte BD mit der Leiterbahn LB und weiteren nicht gezeigten Leiterbahnen an entsprechenden Bondflächen verbunden.

In einem anschliessenden Schritt wird die Sensoranordnung 10 nach Abschluss sämtlicher Verbindungsvorgänge beziehungsweise Löt- oder Klebevorgänge mit einer Moldverpackung MV umspritzt. Dabei verläuft die Unterseite US der Moldverpackung MV im wesentlichen bündig in einer Ebene mit einer unteren Oberfläche 06 des Chipaufnahmebereichs DP, wobei die Oberfläche 06 einer Oberfläche 05 gegenüber liegt, auf die der Montagebereich RB des Chips 1a montiert ist. Die Verbindung zwischen dem Chip 1a und dem Chipaufnahmebereich DP muss dabei für den Moldprozess dicht sein.

Die Anschlusselemente AB ragen aus Seitenflächen SS1, SS2 der Moldverpackung MV, deren planare Oberseite mit OS bezeichnet ist, und sind in üblicher Weise nach oben oder unten gebogen.

Durch diese Art der Montage liegt eine Sensoranordnung 10 vor, bei der optische Strahlung im wesentlichen nur durch das Fenster F auf die Thermopile-Elemente TP bzw. die Absorberschicht A fallen kann, da die Moldverpackung MV-beziehungsweise der etallische-Montagerahmen MLF für die betreffende optische Strahlung nicht transparent sind bzw. abschirmend wirken.

Die Unterseite US der Moldverpackung MV ist im wesentlichen auch in einer Ebene mit den Enden der Anschlusselemente AB' (gemäss JEDEC-Norm für gemoldete Gehäuse der SOP-Form).

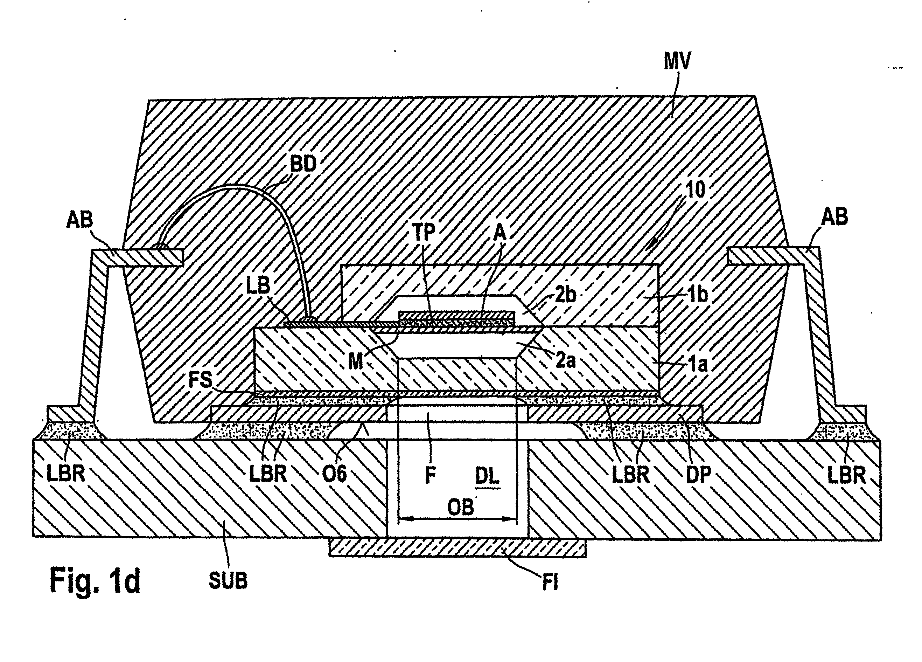

Weiter mit Bezug auf Figur 1d kann die derart verpackte Sensoranordnung 10 auf ein Substrat SUB gelötet werden, welches ein entsprechendes Durchgangsloch DL im Bereich des Fenster F aufweist. Entsprechende Lotbereiche LBR können dabei nicht nur an den Kontaktelementen AB vorgesehen werden, sondern auch an der freiliegenden unteren Oberfläche 06 des Chipaufnahmebereichs DP, was die Stabilität der Anordnung zusätzlich erhöht und für eine gute thermische Anbindung an das Substrat SUB sorgt. Diese Möglichkeit, die verpackte Sensoranordnung am an der Oberfläche O6 freiliegenden Chipaufnahmebereich DP zusätzlich mit den Substrat SUB zu verlöten oder zu verkleben bewirkt nicht nur eine höhere Stabilität, sondern auch eine bessere dynamische Ankopplung an das Substrat SUB.

Der weiteren kann optional auf einer Oberfläche des Substrats SUB beziehungsweise im Durchgangsloch DL eine zusätzliche Filtereinrichtung FI vorgesehen werden. Beispielsweise kann diese zusätzliche Filtereinrichtung auch auswechselbar beziehungsweise einstellbar gestaltet werden, was die Flexibilität der Sensoranordnung zusätzlich erhöht.

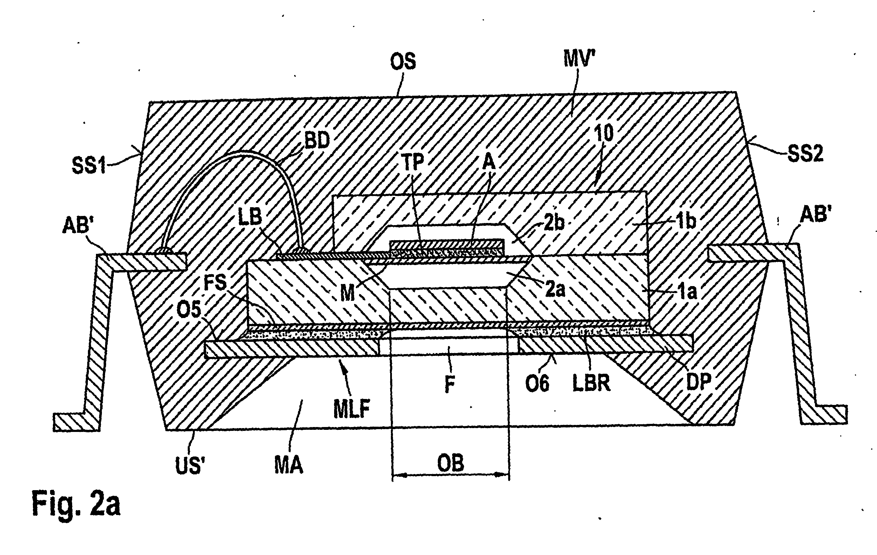

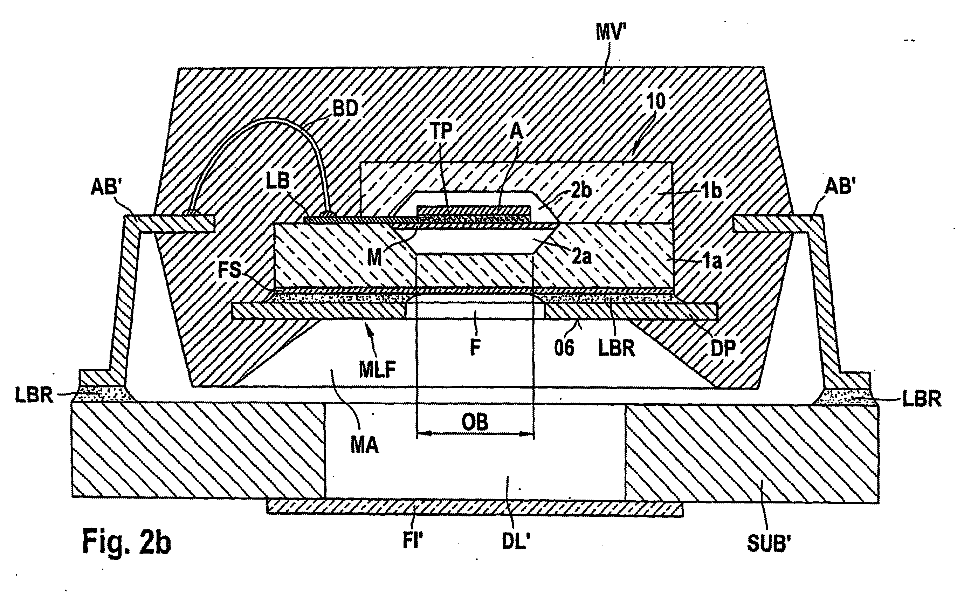

Fig. 2a,b zeigen eine zweite Ausführungsform der erfindungsgemässen Sensorvorrichtung und deren Aufbau.

Bei der in Figur 2a gezeigten zweiten Ausführungsform ist die Moldverpackung MV' andersartig gestaltet als bei der ersten Ausführungsform gemäß Figur 1c. Insbesondere weist die Moldverpackung MV' hier eine Unterseite US' auf, welche in einer tieferen Ebene liegt als die untere Oberfläche 06 des Chipaufnahmebereichs DP, welche ihrerseits auch teilweise von der Moldverpackung MV' bedeckt ist.

Auch bei dieser Ausführungsform ist die Unterseite US' der Moldverpackung MV' im wesentlichen in einer Ebene mit den Enden der Anschlusselementen AB' und lässt durch eine Öffnung MA jedenfalls das Fenster F im optischen Bestrahlungsbereich OB der Sensoranordnung 10 frei. Verfahrensmäßig lässt sich das Freilassen der unteren Oberfläche O6 des Chipaufnahmebereichs DP dadurch realisieren, dass beim Molden ein entsprechender Stempel am Moldwerkzeug in diesem Bereich vorgesehen wird, wobei die Chips 1a,b durch den Montagerahmen MLF vor dem Stempel geschützt sind.

Mit Bezug auf Figur 2b lässt sich diese Anordnung durch entsprechende Lotbereiche LBR über die Anschlusselemente AB' ebenfalls auf ein Substrat SUB' montieren, dass eine entsprechende Filtereinrichtung FI' aufweisen kann. Bei dem Ausführungsbeispiel gemäß Figur 2b ist das Durchgangsloch DL' das Substrats SUB' mit einem größeren Durchmesser versehen als bei der obigen ersten Ausführungsform, was den Raumwinkel für die Bestrahlung des optischen Bestrahlungsbereichs OB erhöht.

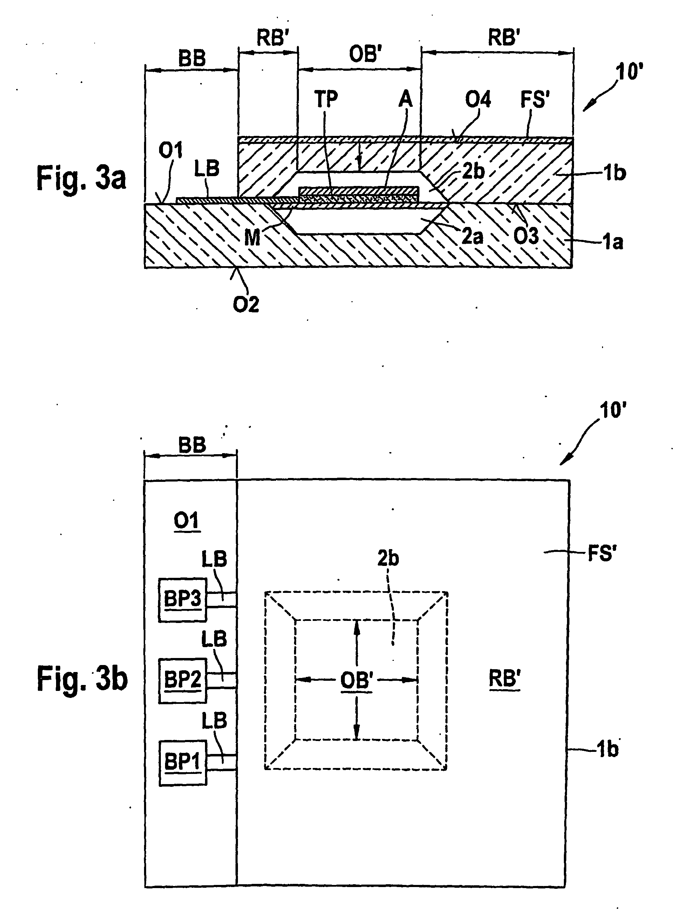

Fig. 3a-d zeigen eine dritte Ausführungsform der erfindungsgemässen Sensorvorrichtung und deren Aufbau.

Die in Figur 3a gezeigt dritte Ausführungsform der vorliegenden Erfindung unterscheidet sich von der oben erläuterten ersten und zweiten Ausführungsform insbesondere darin, dass der optische Bestrahlungsbereich OB' auf der vierten Oberfläche 04 des zweiten Chips 1b liegt, also auf dessen oberer Oberfläche. Somit wird bei dieser dritten Ausführungsform in üblicher Weise die Absorberschicht A bestrahlt. Dem entsprechend ergibt sich ein ringförmiger asymmetrischer Montagebereich RB', der den optischen Bestrahlungsbereich OB umgibt. Auch sind die Filterschichten FS' bei dieser Ausführungsform nicht auf der zweiten Oberfläche 02, sondern entsprechend dem optischen Bestrahlungsbereich OB' auf der vierten Oberfläche 04 vorgesehen.

Ansonsten entsprechen die weiteren Komponenten von Figur 3a den bereits im Zusammenhang mit Figur 1a erläuterten Komponenten.

In der oberen Draufsicht auf diese Sensorvorrichtung gemäß Figur 3b sind der optische Bestrahlungsbereich OB', der diesen umgebende (unter Umständen asymmetrische) Montagebereich RB' und der Drahtbondbereich BB erkennbar, wobei an den Enden der Leiterbahnen LB jeweilige verbreiterte Drahtbondbereiche BP1, BP2, BP3 (auch Bondpads genannt) vorgesehen sind.

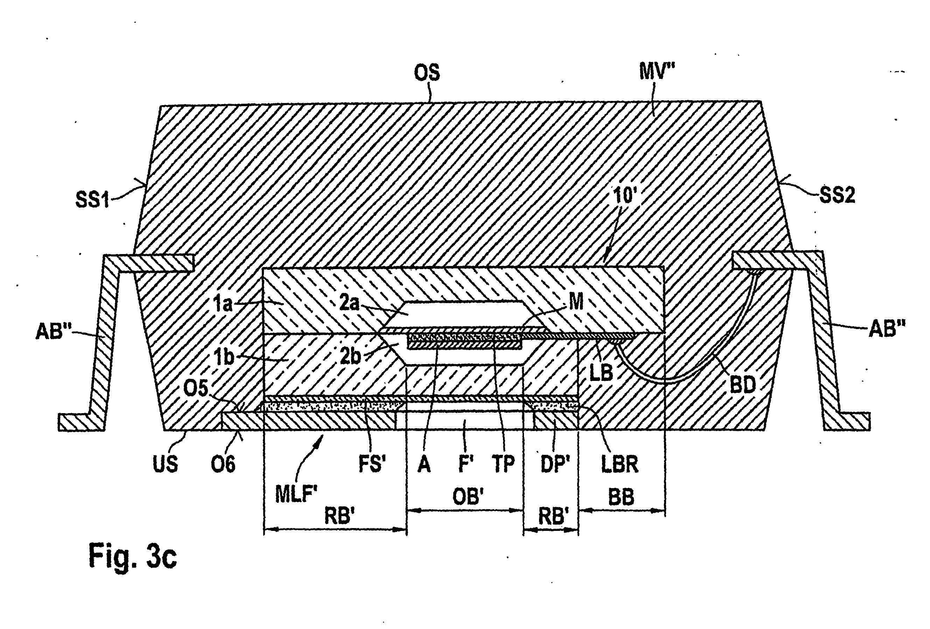

In Analogie zur ersten Ausführungsform gemäß Figur 1c wird, wie in Figur 3c dargestellt, die vierte Oberfläche 04 über den Filterbereich FS' und einen Montagebereich LBR (Kleben oder Löten) auf dem Chipaufnahmebereich DP' derart montiert, dass das Fenster F' des Chipaufnahmebereichs DP' das optische Bestrahlungsfenster OB' der Sensoranordnung 10' freilässt.

Wie aus Figur 3c deutlich erkennbar, ist aufgrund des asymmetrischen Montagebereichs RB' auch die Orientierung des Fensters F' im Chipaufnahmebereich DP' asymmetrisch zu dessen Mitte angeordnet.

Insbesondere ist der Drahtbondbereich BB seitlich gegenüber dem Chipaufnahmebereich DP' versetzt, um eine Kontaktierung mittels des Bonddrahtes BD vom Anschlusselement AB" in einfacher Weise zu ermöglichen.

Nach Montage der Chips und Kontaktierung mit Drähten erfolgt das Umspritzen mit der Moldverpackung MV" analog zu der ersten Ausführungsform gemäß Figur 1c, wobei wiederum die untere Oberfläche 06 des Chipanschlussbereichs DP' in einer Ebene mit der Unterseite US der Moldverpackung MV" verläuft und vollständig freiliegt. Auch die Anschlusselemente AB" verlaufen an ihren Enden im Bereich dieser Ebene nach JEDEC-Norm, wie Figur 3c deutlich entnehmbar.

Mit Bezug auf Figur 3d wird die derart aufgebaute Chipanordnung auf einem Substrat SUB" mit einer Durchgangsöffnung DL" analog zur Durchgangsöffnung gemäß Figur 1d montiert. Die Verbindung erfolgt über Lotbereiche LBR zwischen den Anschlusselementen RB" und dem Substrat SUB" und optional zwischen der Oberfläche 06 des Chipaufnahmebereichs DP' und dem Substrat SUB".

Ebenfalls vorgesehen ist eine optionale Filtereinrichtung FI" auf der der Chipanordnung 10' abgewandten Seite des Substrats SUB".

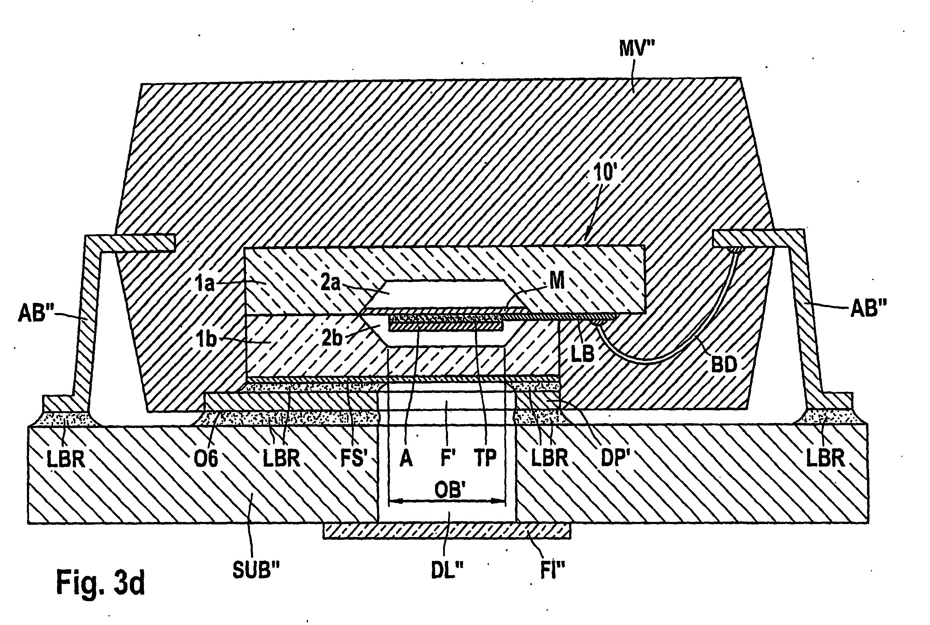

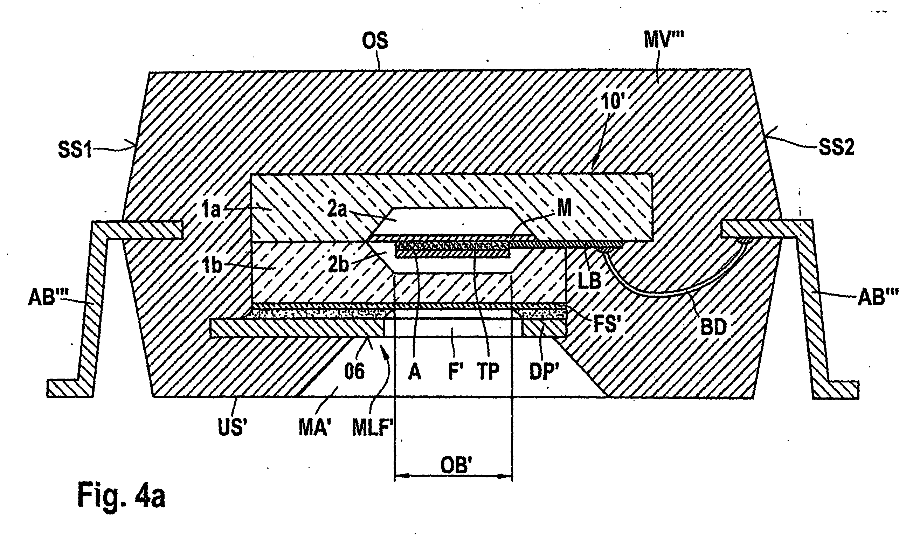

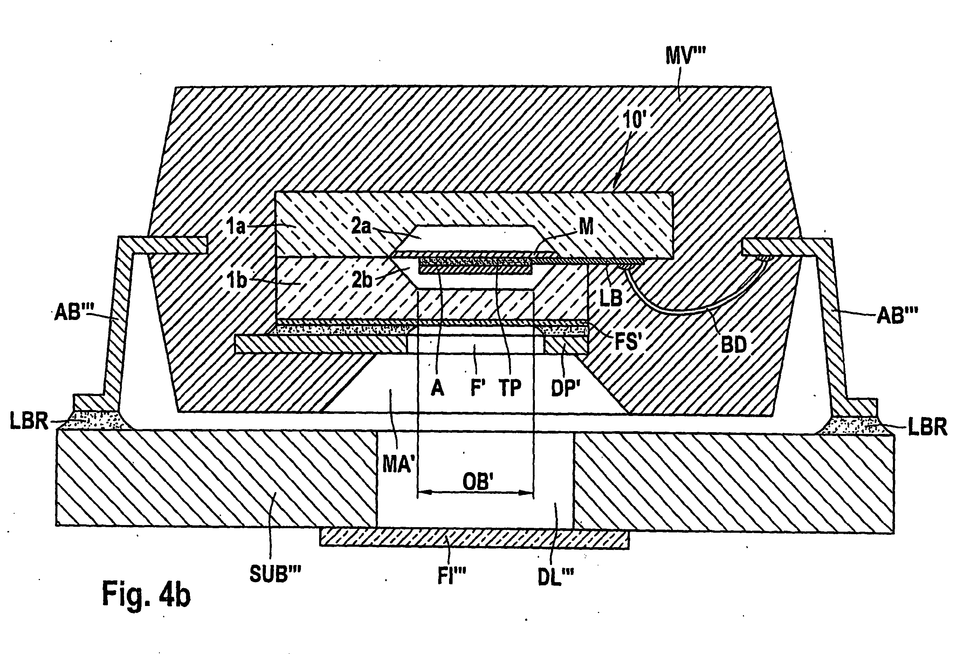

Fig. 4a,b zeigen eine vierte Ausführungsform der erfindungsgemässen Sensorvorrichtung und deren Aufbau.

Mit Bezug auf Figur 4a verläuft bei dieser vierten Ausführungsform die Unterseite US' in einer Ebene unterhalb der Oberfläche 06 des Chipaufnahmebereichs DP'. Entsprechend ist eine Öffnung MA' in der Moldverpackung MV''' vorgesehen, welche das Fenster F' und damit den optischen Bestrahlungsbereich OB' freilässt.

Schließlich mit bezug auf Figur 4b erfolgt bei dieser Ausführungsform analog zu Figur 3b eine Montage der verpackten Chipanordnung 10' über die Anschlusselemente AB''' auf einen Substrat SUB''' über Lotbereiche LBR.

Ebenfalls vorgesehen hier ist die Filtereinrichtung FI'" auf der der Chipanordnung abgewandten Seite des Substrats.

Obwohl die vorliegende Erfindung vorstehend anhand eines bevorzugten Ausführungsbeispiels beschrieben wurde, ist sie darauf nicht beschränkt, sondern auf vielfältige Weise modifizierbar.

Obwohl bei den obigen Ausführungsformen nicht gezeigt, können selbstverständlich die Anschlusselemente in beliebige Richtungen hinsichtlich des Chipaufnahmebereichs DP gerichtet sein, so dass auch eine "umgekehrte" Montage auf dem Substrat möglich ist und das Substrat kein Fenster benötigt.

Auch ist es möglich, die Chipanordnung nicht auf den Montagerahmen zu löten, sondern zu kleben.

Des weiteren können alternative oder weitere Filteranordnungen auf die freiliegende Oberfläche des Chipaufnahmebereichs aufgebracht werden.

### BEZUGSZEICHENLISTE:

| | |
|---|---|
| BB | Drahtbondbereich |
| OB,OB' | Optischer Bestrahlungsbereich |
| RB,RB' | Montagebereich |
| 10,10' | Sensorchipanordnung |
| 1a,1b | erster, zweiter Chip |
| 2a,b | Hohlraum |
| O1-O6 | Oberflächen |
| M | Membran |
| TP | Thermopile-Sensoren |
| A | Absorberschicht |
| FS,FS' | Filterschicht |
| LBR | Lotbereich |
| MLF,MLF' | Montagerahmen |
| DP,DP' | Chipaufnahmebereich |
| AB-AB'" | Anschlusselemente |
| MV-MV"' | Moldverpackung |
| BD | Bonddraht |
| US,US' | Unterseite |
| OS | Oberseite |
| SS1,SS2 | Seitenflächen |
| F,F' | Fenster |
| DL-DL''' | Durchgangsloch |
| MA,MA' | Öffnung |
| SUB-SUB'" | Substrat |
| FI-FI"' | Filtereinrichtung |
| BPI-BP3 | Bondflächen |
| LB | Leiterbahn |

## Patentansprüche (Patentansprüche für folgende(n) Vertragsstaat(en): SE, FR, IT)

1. Optische Sensoranordnung, insbesondere Thermopile-Sensoranordnung, mit:
einer Sensorchipanordnung (10; 10') mit einem optisch transparenten Bestrahlungsbereich (OB; OB'), einem diesen umgebenden Montagebereich (RB; RB') und einem Drahtbondbereich (BB);
einem optisch isolierenden Montagerahmen (MLF; MLF') mit einem Chipaufnahmebereich (DP; DP') und einer Mehrzahl Anschlusselementen (AB-AB'''); und
einer optisch isolierenden Verpackungeinrichtung (MV-MV''');
wobei
die Sensorchipanordnung (10; 10') im Montagebereich (RB; RB') mit dem Chipaufnahmebereich (DP; DP') und im Drahtbondbereich (BB) mit einem oder mehreren der Anschlusselemente (AB-AB'") verbunden ist;
die Chipaufnahmebereich (LB; LB') ein derart angeordnetes Fenster (F; F') aufweist, das zumindest ein Teil des optischen Bestrahlungsbereichs (OB; OB') nicht von dem Chipaufnahmebereich (DP; DP') bedeckt ist; und
die Verpackungeinrichtung (MV-MV'") die Sensorchipanordnung (10; 10') und den Montagerahmen (MLF: MLF') derart umgibt, dass optische Strahlung im wesentlichen nur durch das Fenster (F; F') in die Sensorchipanordnung (10; 10') eintreten kann.

2. Optische Sensoranordnung nach Anspruch 1, **dadurch gekennzeichnet, dass** die Sensorchipanordnung (10; 10') einen ersten Chip (1a) mit einer ersten und einer zweiten gegenüberliegenden Oberfläche (O1, 02) und einen zweiten Chip (1b) mit einer dritten und einer vierten gegenüberliegenden Oberfläche (03, 04) aufweist, welche über die erste und dritte Oberfläche (O1, 03) verbunden sind und einen Hohlraum (2a, 2b) einschliessen, in dem ein Sensor (A, TP, M) angeordnet ist; und der erste Chip (1a) auf der ersten Oberfläche (O1) den Drahtbondbereich (BB) aufweist, der seitlich über den zweiten Chip (1b) vorsteht und auf den mindestens ein an ein Anschlusselement (AB-AB"') gebondeter Bonddraht (BD) geführt ist.

3. Optische Sensoranordnung nach Anspruch 2, **dadurch gekennzeichnet, dass** der optisch transparent Bestrahlungsbereich (OB; OB') und der umgebende Montagebereich (RB; RB') auf der zweiten Oberfläche (02) des ersten Chips (1a) vorgesehen sind.

4. Optische Sensoranordnung nach Anspruch 2, **dadurch gekennzeichnet, dass** der optisch transparent Bestrahlungsbereich (OB; OB') und der umgebende Montagebereich (RB; RB') auf der vierten Oberfläche (04) des zweiten Chips (1b) vorgesehen sind.

5. Optische Sensoranordnung nach Anspruch 3 oder 4, **dadurch gekennzeichnet, dass** der Chipaufnahmebereich (DP; DP') eine fünfte und eine sechste gegenüberliegende Oberfläche (O5, O6) aufweist und die fünfte Oberfläche (O5) mit dem Montagebereich (RB) verbunden ist.

6. Optische Sensoranordnung nach Anspruch 5, **dadurch gekennzeichnet, dass** die sechste Oberfläche (06) nicht von der Verpackungeinrichtung (MV, MV") bedeckt ist und mit einer Unterseite (US) der Verpackungeinrichtung (MV, MV") in einer Ebene liegt.

7. Optische Sensoranordnung nach Anspruch 6, **dadurch gekennzeichnet, dass** die Anschlusselementen (AB, AB") aus gegenüberliegenden Seitenflächen (SSW1, SS2) der Verpackungeinrichtung (MV, MV") herausragen und ihre Enden in der Ebene der Unterseite (US) liegen.

8. Optische Sensoranordnung nach Anspruch 7, **dadurch gekennzeichnet, dass** die Enden der Anschlusselemente (AB, AB") und optional die sechste Oberfläche (06) mit einem Substrat (SUB, SUB") verbunden sind, welches ein Durchgangsloch (DL-DL''') im Bereich des Fensters (F; F') aufweist.

9. Optische Sensoranordnung nach Anspruch 5, **dadurch gekennzeichnet, dass** die sechste Oberfläche (06) teilweise von der Verpackungeinrichtung (MV, MV") bedeckt ist und eine Unterseite (US') der Verpackungeinrichtung (MV, MV") in einer Ebene unterhalb der sechsten Oberfläche (06) liegt.

10. Optische Sensoranordnung nach Anspruch 9, **dadurch gekennzeichnet, dass** die Anschlusselemente (AB, AB") aus gegenüberliegenden Seitenflächen (SSW1, SS2) der Verpackungeinrichtung (MV, MV") herausragen und ihre Enden in der Ebene der Unterseite (US') liegen.

11. Optische Sensoranordnung nach Anspruch 10, **dadurch gekennzeichnet, dass** die Enden der Anschlusselemente (AB, AB") mit einem Substrat (SUB, SUB") verbunden sind, welches ein Durchgangsloch (DL-DL") im Bereich des Fensters (F; F') aufweist.

12. Optische Sensoranordnung nach einem der Ansprüche 8 oder 11, **dadurch gekennzeichnet, dass** auf der zweiten bzw. vierten Oberfläche (02, 04) des ersten Chips (1a) und/oder am Substrat (SUB, SUB") im Bereich des Durchgangslochs (DL-DL"') eine optische Filtereinrichtung (FS; FI; FI") vorgesehen ist.

13. Optische Sensoranordnung nach einem der vorhergehenden Ansprüche, **dadurch gekennzeichnet, dass** der Montagerahmen (MLF: MLF') ein Lötrahmen ist.

14. Optische Sensoranordnung nach einem der vorhergehenden Ansprüche 4 bis 13, **dadurch gekennzeichnet, dass** der Drahtbondbereich (BB) seitlich über den Chipaufnahmebereich (DP') vorsteht.

15. Verfahren zur Herstellung einer optische Sensoranordnung nach einem der vorhergehenden Ansprüche, **gekennzeichnet durch** die Schritte:
Verbinden der Sensorchipanordnung (10; 10') im Montagebereich (RB; RB') mit dem Chipaufnahmebereich (DP; DP') und im Drahtbondbereich (BB) mit dem einem oder den mehreren der Anschlusselemente (AB-AB'"); und
Aufbringen der Verpackungeinrichtung (MV-MV"') in einem Molding-Prozess.

## Patentansprüche (Patentansprüche für folgende(n) Vertragsstaat(en): DE)

1. Optische Sensoranordnung, insbesondere Thermopile-Sensoranordnung, mit:
einer Sensorchipanordnung (10; 10') mit einem optisch transparenten Bestrahlungsbereich (OB; OB'), einem diesen umgebenden Montagebereich (RB; RB') und einem Drahtbondbereich (BB);
einem optisch isolierenden Montagerahmen (MLF; MLF') mit einem Chipaufnahmebereich (DP; DP') und einer Mehrzahl Anschlusselementen (AB-AB"'); und
einer optisch isolierenden Verpackungeinrichtung (MV-MV"');
wobei
die Sensorchipanordnung (10; 10') im Montagebereich (RB; RB') mit dem Chipaufnahmebereich (DP; DP') und im Drahtbondbereich (BB) mit einem oder mehreren der Anschlusselemente (AB-AB''') verbunden ist;
die Chipaufnahmebereich (LB; LB') ein derart angeordnetes Fenster (F; F') aufweist, das zumindest ein Teil des optischen Bestrahlungsbereichs (OB; OB') nicht von dem Chipaufnahmebereich (DP; DP') bedeckt ist; und
die Verpackungeinrichtung (MV-MV''') die Sensorchipanordnung (10; 10') und den Montagerahmen (MLF: MLF') derart umgibt, dass optische Strahlung im wesentlichen nur durch das Fenster (F; F') in die Sensorchipanordnung (10; 10') eintreten kann,
wobei die Sensorchipanordnung (10; 10') einen ersten Chip (1a) mit einer ersten und einer zweiten gegenüberliegenden Oberfläche (O1, 02) und einen zweiten Chip (1b) mit einer dritten und einer vierten gegenüberliegenden Oberfläche (03, 04) aufweist, welche über die erste und dritte Oberfläche (O1, O3) verbunden sind und einen Hohlraum (2a, 2b) einschliessen, in dem ein Sensor (A, TP, M) angeordnet ist; und der erste Chip (1a) auf der ersten Oberfläche (O1) den Drahtbondbereich (BB) aufweist, der seitlich über den zweiten Chip (1b) vorsteht und auf den mindestens ein an ein Anschlusselement (AB-AB''') gebondeter Bonddraht (BD) geführt ist"

2. Optische Sensoranordnung nach Anspruch 1, **dadurch gekennzeichnet, dass** der optisch transparent Bestrahlungsbereich (OB; OB') und der umgebende Montagebereich (RB; RB') auf der zweiten Oberfläche (02) des ersten Chips (1a) vorgesehen sind.

3. Optische Sensoranordnung nach Anspruch 1, **dadurch gekennzeichnet, dass** der optisch transparent Bestrahlungsbereich (OB; OB') und der umgebende Montagebereich (RB; RB') auf der vierten Oberfläche (04) des zweiten Chips (1b) vorgesehen sind.

4. Optische Sensoranordnung nach Anspruch 2 oder 3, **dadurch gekennzeichnet, dass** der Chipaufnahmebereich (DP; DP') eine fünfte und eine sechste gegenüberliegende Oberfläche (O5, 06) aufweist und die fünfte Oberfläche (O5) mit dem Montagebereich (RB) verbunden ist.

5. Optische Sensoranordnung nach Anspruch 4, **dadurch gekennzeichnet, dass** die sechste Oberfläche (06) nicht von der Verpackungeinrichtung (MV, MV") bedeckt ist und mit einer Unterseite (US) der Verpackungeinrichtung (MV, MV") in einer Ebene liegt.

6. Optische Sensoranordnung nach Anspruch 5, **dadurch gekennzeichnet, dass** die Anschlusselementen (AB, AB") aus gegenüberliegenden Seitenflächen (SSW1, SS2) der Verpackungeinrichtung (MV, MV") herausragen und ihre Enden in der Ebene der Unterseite (US) liegen.

7. Optische Sensoranordnung nach Anspruch 6, **dadurch gekennzeichnet, dass** die Enden der Anschlusselemente (AB, AB") und optional die sechste Oberfläche (06) mit einem Substrat (SUB, SUB") verbunden sind, welches ein Durchgangsloch (DL-DL"') im Bereich des Fensters (F; F') aufweist.

8. Optische Sensoranordnung nach Anspruch 4, **dadurch gekennzeichnet, dass** die sechste Oberfläche (O6) teilweise von der Verpackungeinrichtung (MV, MV") bedeckt ist und eine Unterseite (US') der Verpackungeinrichtung (MV, MV") in einer Ebene unterhalb der sechsten Oberfläche (06) liegt.

9. Optische Sensoranordnung nach Anspruch 8, **dadurch gekennzeichnet, dass** die Anschlusselemente (AB, AB") aus gegenüberliegenden Seitenflächen (SSW1, SS2) der Verpackungeinrichtung (MV, MV") herausragen und ihre Enden in der Ebene der Unterseite (US') liegen.

10. Optische Sensoranordnung nach Anspruch 9, **dadurch gekennzeichnet, dass** die Enden der Anschlusselemente (AB, AB") mit einem Substrat (SUB, SUB") verbunden sind, welches ein Durchgangsloch (DL-DL") im Bereich des Fensters (F; F') aufweist.

11. Optische Sensoranordnung nach einem der Ansprüche 7 oder 10, **dadurch gekennzeichnet, dass** auf der zweiten bzw. vierten Oberfläche (02, 04) des ersten Chips (1a) und/oder am Substrat (SUB, SUB") im Bereich des Durchgangslochs (DL-DL"') eine optische Filtereinrichtung (FS; FI; FI") vorgesehen ist.

12. Optische Sensoranordnung nach einem der vorhergehenden Ansprüche, **dadurch gekennzeichnet, dass** der Montagerahmen (MLF: MLF') ein Lötrahmen ist.

13. Optische Sensoranordnung nach einem der vorhergehenden Ansprüche 3 bis 12, **dadurch gekennzeichnet, dass** der Drahtbondbereich (BB) seitlich über den Chipaufnahmebereich (DP') vorsteht.

14. Verfahren zur Herstellung einer optische Sensoranordnung nach einem der vorhergehenden Ansprüche, **gekennzeichnet durch** die Schritte:
Verbinden der Sensorchipanordnung (10; 10') im Montagebereich (RB; RB') mit dem Chipaufnahmebereich (DP; DP') und im Drahtbondbereich (BB) mit dem einem oder den mehreren der Anschlusselemente (AB-AB'"); und
Aufbringen der Verpackungeinrichtung (MV-MV"') in einem Molding-Prozess.

## Claims (Claims for the following Contracting State(s): SE, FR, IT)

1. Optical sensor arrangement, in particular thermopile sensor arrangement, comprising:
a sensor chip arrangement (10; 10') with an optically transparent irradiation region (OB, OB'), a mounting region (RB; RB') surrounding the latter, and a wire bonding region (BB);
an optically isolating mounting frame (MLF; MLF') with a chip receptacle region (DP; DP') and a plurality of connection elements (AB-AB'''); and an optically isolating packaging device (MV-MV''');
wherein
the sensor chip arrangement (10; 10') is connected to the chip receptacle region (DP; DP') in the mounting region (RB; RB') and to one or more of the connection elements (AB-AB''') in the wire bonding region (BB);
the chip receptacle region (LB; LB') has a window (F; F') arranged in such a way that at least one part of the optical irradiation region (OB; OB') is not covered by the chip receptacle region (DP; DP'); and
the packaging device (MV-MV''') surrounds the sensor chip arrangement (10; 10') and the mounting frame (MLF; MLF') in such a way that optical radiation can enter into the sensor chip arrangement (10; 10') essentially only through the window (F; F').

2. Optical sensor arrangement according to Claim 1, **characterized in that** the sensor chip arrangement (10; 10') has a first chip (1a) having a first and a second opposite surface (01, 02) and a second chip (1b) having a third and a fourth opposite surface (03, 04), which are connected via the first and third surfaces (01, 03) and enclose a cavity (2a, 2b), in which a sensor (A, TP, M) is arranged; and the first chip (1a) has on the first surface (01) the wire bonding region (BB), which projects laterally beyond the second chip (1b) and onto which is led at least one bonding wire (BD) bonded to a connection element (AB-AB"').

3. Optical sensor arrangement according to Claim 2, **characterized in that** the optically transparent irradiation region (OB; OB') and the surrounding mounting region (RB; RB') are provided on the second surface (02) of the first chip (1a).

4. Optical sensor arrangement according to Claim 2, **characterized in that** the optically transparent irradiation region (OB; OB') and the surrounding mounting region (RB; RB') are provided on the fourth surface (04) of the second chip (1b).

5. Optical sensor arrangement according to Claim 3 or 4, **characterized in that** the chip receptacle region (DP; DP') has a fifth and a sixth opposite surface (05, 06) and the fifth surface (05) is connected to the mounting region (RB).

6. Optical sensor arrangement according to Claim 5, **characterized in that** the sixth surface (06) is not covered by the packaging device (MV, MV") and lies in one plane with an underside (US) of the packaging device (MV, MV").

7. Optical sensor arrangement according to Claim 6, **characterized in that** the connection elements (AB, AB") project from opposite side areas (SSW1, SS2) of the packaging device (MV, MV") and their ends lie in the plane of the underside (US).

8. Optical sensor arrangement according to Claim 7, **characterized in that** the ends of the connection elements (AB, AB") and optionally the sixth surface (06) are connected to a substrate (SUB, SUB") having a passage hole (DL-DL''') in the region of the window (F; F').

9. Optical sensor arrangement according to Claim 5, **characterized in that** the sixth surface (06) is partly covered by the packaging device (MV, MV") and an underside (US') of the packaging device (MV, MV") lies in a plane below the sixth surface (06).

10. Optical sensor arrangement according to Claim 9, **characterized in that** the connection elements (AB, AB") project from opposite side areas (SSW1, SS2) of the packaging device (MV, MV") and their ends lie in the plane of the underside (US').

11. Optical sensor arrangement according to Claim 10, **characterized in that** the ends of the connection elements (AB, AB") are connected to a substrate (SUB, SUB") having a passage hole (DL-DL") in the region of the window (F; F').

12. Optical sensor arrangement according to either of Claims 8 and 11, **characterized in that** an optical filter device (FS; FI; FI") is provided on the second or fourth surface (02, 04) of the first chip (1a) and/or at the substrate (SUB, SUB") in the region of the passage hole (DL-DL"').

13. Optical sensor arrangement according to one of the preceding claims, **characterized in that** the mounting frame (MLF; MLF') is a soldering frame.

14. Optical sensor arrangement according to one of the preceding Claims 4 to 13, **characterized in that** the wire bonding region (BB) projects laterally beyond the chip receptacle region (DP').

15. Method for producing an optical sensor arrangement according to one of the preceding claims, **characterized by** the steps of:
connecting the sensor chip arrangement (10; 10') to the chip receptacle region (DP; DP') in the mounting region (RB; RB') and to the one or more of the connection elements (AB-AB"') in the wire bonding region (BB); and
applying the packaging device (MV-MV"') in a moulding process.

## Claims (Claims for the following Contracting State(s): DE)

1. Optical sensor arrangement, in particular thermopile sensor arrangement, comprising:
a sensor chip arrangement (10; 10') with an optically transparent irradiation region (OB, OB'), a mounting region (RB; RB') surrounding the latter, and a wire bonding region (BB);
an optically isolating mounting frame (MLF; MLF') with a chip receptacle region (DP; DP') and a plurality of connection elements (AB-AB"'); and
an optically isolating packaging device (MV-MV''');
wherein
the sensor chip arrangement (10; 10') is connected to the chip receptacle region (DP; DP') in the mounting region (RB; RB') and to one or more of the connection elements (AB-AB''') in the wire bonding region (BB);
the chip receptacle region (LB;.LB') has a window (F; F') arranged in such a way that at least one part of the optical irradiation region (OB; OB') is not covered by the chip receptacle region (DP; DP'); and
the packaging device (MV-MV''') surrounds the sensor chip arrangement (10; 10') and the mounting frame (MLF; MLF') in such a way that optical radiation can enter into the sensor chip arrangement (10; 10') essentially only through the window (F; F'),
wherein the sensor chip arrangement (10; 10') has a first chip (1a) having a first and a second opposite surface (01, 02) and a second chip (1b) having a third and a fourth opposite surface (03, 04), which are connected via the first and third surfaces (01, 03) and enclose a cavity (2a, 2b), in which a sensor (A, TP, M) is arranged; and the first chip (1a) has on the first surface (01) the wire bonding region (BB), which projects laterally beyond the second chip (1b) and onto which is led at least one bonding wire (BD) bonded to a connection element (AB-AB''').

2. Optical sensor arrangement according to Claim 1, **characterized in that** the optically transparent irradiation region (OB; OB') and the surrounding mounting region (RB; RB') are provided on the second surface (02) of the first chip (1a).

3. Optical sensor arrangement according to Claim 1, **characterized in that** the optically transparent irradiation region (OB; OB') and the surrounding mounting region (RB; RB') are provided on the fourth surface (04) of the second chip (1b).

4. Optical sensor arrangement according to Claim 2 or 3, **characterized in that** the chip receptacle region (DP; DP') has a fifth and a sixth opposite surface (05, 06) and the fifth surface (05) is connected to the mounting region (RB).

5. Optical sensor arrangement according to Claim 4, **characterized in that** the sixth surface (06) is not covered by the packaging device (MV, MV") and lies in one plane with an underside (US) of the packaging device (MV, MV").

6. Optical sensor arrangement according to Claim 5, **characterized in that** the connection elements (AB, AB") project from opposite side areas (SSW1, SS2) of the packaging device (MV, MV") and their ends lie in the plane of the underside (US).

7. Optical sensor arrangement according to Claim 6, **characterized in that** the ends of the connection elements (AB, AB") and optionally the sixth surface (06) are connected to a substrate (SUB, SUB") having a passage hole (DL-DL''') in the region of the window (F; F').

8. Optical sensor arrangement according to Claim 4, **characterized in that** the sixth surface (06) is partly covered by the packaging device (MV, MV") and an underside (US') of the packaging device (MV, MV'') lies in a plane below the sixth surface (06).

9. Optical sensor arrangement according to Claim 8, **characterized in that** the connection elements (AB, AB") project from opposite side areas (SSW1, SS2) of the packaging device (MV, MV") and their ends lie in the plane of the underside (US').

10. Optical sensor arrangement according to Claim 9, **characterized in that** the ends of the connection elements (AB, AB") are connected to a substrate (SUB, SUB") having a passage hole (DL-DL") in the region of the window (F; F').

11. Optical sensor arrangement according to either of Claims 7 and 10, **characterized in that** an optical filter device (FS; FI; FI") is provided on the second or fourth surface (02, 04) of the first chip (1a) and/or at the substrate (SUB, SUB") in the region of the passage hole (DL-DL''').

12. Optical sensor arrangement according to one of the preceding claims, **characterized in that** the mounting frame (MLF; MLF') is a soldering frame.

13. Optical sensor arrangement according to one of the preceding Claims 3 to 12, **characterized in that** the wire bonding region (BB) projects laterally beyond the chip receptacle region (DP').

14. Method for producing an optical sensor arrangement according' to one of the preceding claims, **characterized by** the steps of:
connecting the sensor chip arrangement (10; 10') to the chip receptacle region (DP; DP') in the mounting region (RB; RB') and to the one or more of the connection elements (AB-AB''') in the wire bonding region (BB); and
applying the packaging device (MV-MV"') in a moulding process.

## Revendications (Revendications pour l'(les) Etat(s) contractant(s) suivant(s): SE, FR, IT)

1. Dispositif de détection optique, en particulier dispositif de détection à thermopile, comprenant :
un dispositif de puce de détection (10 ; 10') doté d'une zone de rayonnement optiquement transparente (OB ; OB'), d'une zone de montage entourant celle-ci (RB ; RB') et d'une zone de liaison par fil (BB) ;
un cadre de montage optiquement isolant (MLF ; MLF') doté d'une zone de réception de puce (DP ; DP') et d'une pluralité d'éléments de connexion (AB-AB''') ; et
un dispositif d'emballage optiquement isolant (MV-MV''') ;
dans lequel
le dispositif de puce de détection (10 ; 10') est relié dans la zone de montage (RB ; RB') à la zone de réception de puce (DP ; DP'), et dans la zone de liaison câblée (BB) à un ou plusieurs éléments de connexion (AB-AB''') ;
la zone de réception de puce (LB ; LB') présente une fenêtre (F ; F') disposée de telle sorte qu'au moins une partie de la zone de rayonnement optique (OB ; OB') n'est pas recouverte par la zone de réception de puce (DP ; DP') ; et
le dispositif d'emballage (MV-MV''') entoure le dispositif de puce de détection (10 ; 10') et le cadre de montage (MLF ; MLF') de telle sorte que le rayonnement optique peut pénétrer dans le dispositif de puce de détection (10 ; 10') pour l'essentiel uniquement à travers la fenêtre (F ; F').

2. Dispositif de détection optique selon la revendication 1,
**caractérisé en ce que**
le dispositif de puce de détection (10 ; 10') présente une première puce (1a) dotée d'une première et d'une deuxième surfaces opposées (O1, 02) et une deuxième puce (1b) dotée d'une troisième et d'une quatrième surfaces opposées (03, 04), reliées par la première et la troisième surfaces (O1, O3) et incluant un espace creux (2a, 2b) logeant un capteur (A, TP, M) ; et la première puce (1a) présente, sur la première surface (O1) la zone de liaison par fil (BB), qui dépasse latéralement de la deuxième puce (1b) et est guidée sur au moins un câble de liaison (DB) relié à un élément de connexion (AB-AB"').

3. Dispositif de détection optique selon la revendication 2,
**caractérisé en ce que**
la zone de rayonnement optiquement transparente (OB ; OB') et la zone de montage périphérique (RB ; RB') sont prévues sur la deuxième surface (02) de la première puce (1a).

4. Dispositif de détection optique selon la revendication 2,
**caractérisé en ce que**
la zone de rayonnement optiquement transparente (OB ; OB') et la zone de montage périphérique (RB ; RB') sont prévues sur la quatrième surface (04) de la deuxième puce (1b).

5. Dispositif de détection optique selon la revendication 3 ou 4,
**caractérisé en ce que**
la zone de réception de puce (DP ; DP') présente une cinquième et une sixième surfaces opposées (05, 06) et la cinquième surface (05) est reliée à une zone de montage (RB).

6. Dispositif de détection optique selon la revendication 5,
**caractérisé en ce que**
la deuxième surface (06) n'est pas recouverte par le dispositif d'emballage (MV, MV") et se trouve dans le même plan qu'une face inférieure (US) du dispositif d'emballage (MV, MV").

7. Dispositif de détection optique selon la revendication 6,
**caractérisé en ce que**
les éléments de connexion (AB, AB") dépassent de surfaces latérales opposées (SSW1, SS2) du dispositif d'emballage (MV, MV") et leurs extrémités se trouvent dans le plan de la face inférieure (US).

8. Dispositif de détection optique selon la revendication 7,
**caractérisé en ce que**
les extrémités des éléments de connexion (AB, AB") et en option la sixième surface (06) sont reliées à un substrat (SUB, SUB') qui présente un trou débouchant (DL-DL'") dans la zone de la fenêtre (F ; F').

9. Dispositif de détection optique selon la revendication 5,
**caractérisé en ce que**
la sixième surface (06) est partiellement recouverte par le dispositif d'emballage (MV, MV") et une face inférieure (US') du dispositif d'emballage (MV, MV") se trouve dans un plan en dessous de la face inférieure (US').

10. Dispositif de détection optique selon la revendication 9,
**caractérisé en ce que**
les éléments de connexion (AB, AB") dépassent au niveau de surfaces latérales opposées (SSW1, SS2) du dispositif d'emballage (MV, MV") et leurs extrémités se trouvent dans le plan de la face inférieure (US').

11. Dispositif de détection optique selon la revendication 10,
**caractérisé en ce que**
les extrémités des éléments de connexion (AB, AB") sont reliées à un substrat (SUB, SUB") qui présente un trou débouchant (DL-DL") dans la zone de la fenêtre (F ; F').

12. Dispositif de détection optique selon l'une des revendications 8 ou 11,
**caractérisé en ce que**
sur la deuxième ou la quatrième surface (02, 04) de la première puce (1a) et/ou au niveau du substrat (SUB, SUB") dans la zone du trou débouchant (DL-DL"=), on prévoit un dispositif de filtration optique (FS; FI; FI").

13. Dispositif de détection optique selon l'une des revendications précédentes,
**caractérisé en ce que**
le cadre de montage (MLF ; MLF') est un cadre soudé.

14. Dispositif de détection optique selon l'une des revendications 4 à 13,
**caractérisé en ce que**
la zone de liaison par fil (BB) dépasse latéralement de la zone de réception de puce (DP').

15. Procédé de fabrication d'un dispositif de détection optique selon l'une des revendications précédentes,
**caractérisé par**
les étapes suivantes :
liaison du dispositif de puce de détection (10 ; 10') dans la zone de montage (RB ; RB') avec la zone de réception de puce (DP ; DP'), et dans la zone de liaison par fil (BB) avec un ou plusieurs éléments de connexion (AB-AB'') ; et
mise en place du dispositif d'emballage (MV-MV"') dans un processus de moulage.

## Revendications (Revendications pour l'(les) Etat(s) contractant(s) suivant(s): DE)

1. Dispositif de détection optique, en particulier dispositif de détection à thermopile, comprenant :
un dispositif de puce de détection (10 ; 10') doté d'une zone de rayonnement optiquement transparente (OB ; OB'), d'une zone de montage entourant celle-ci (RB ; RB') et d'une zone de liaison par fil (BB) ;
un cadre de montage optiquement isolant (MLF ; MLF') doté d'une zone de réception de puce (DP ; DP') et d'une pluralité d'éléments de connexion (AB-AB'") ; et
un dispositif d'emballage optiquement isolant (MV-MV"') ;
dans lequel
le dispositif de puce de détection (10 ; 10'), est relié dans la zone de montage (RB ; RB') à la zone de réception de puce (DP ; DP'), et dans la zone de liaison par fil (BB) à un ou plusieurs éléments de connexion (AB-AB"') ;
la zone de réception de puce (LB ; LB') présente une fenêtre (F ; F') disposée de telle sorte qu'au moins une partie de la zone de rayonnement optique (OB ; OB') n'est pas recouverte par la zone de réception de puce (DP ; DP') ; et
le dispositif d'emballage (MV-MV''') entoure le dispositif de puce de détection (10 ; 10') et le cadre de montage (MLF ; MLF') de telle sorte que le rayonnement optique peut pénétrer dans le dispositif de puce de détection (10 ; 10') pour l'essentiel uniquement à travers la fenêtre (F ; F'),
le dispositif de puce de détection (10 ; 10') présentant une première puce (1a) dotée d'une première et d'une deuxième surfaces opposées (O1, 02) et une deuxième puce (1b) dotée d'une troisième et d'une quatrième surfaces opposées (03, 04), reliées par la première et la troisième surfaces (O1, 03) et incluant un espace creux (2a, 2b) logeant un capteur (A, TP, M) ; et la première puce (1a) présente sur la première surface (O1) la zone de liaison par fil (BB) qui dépasse latéralement de la deuxième puce (1b), et guidée sur au moins un fil de liaison (DB) relié à un élément de connexion (AB-AB"').

2. Dispositif de détection optique selon la revendication 1,
**caractérisé en ce que**
la zone de rayonnement optiquement transparente (OB ; OB') et la zone de montage périphérique (RB ; RB') sont prévues sur la deuxième surface (02) de la première puce (1a).

3. Dispositif de détection optique selon la revendication 1,
**caractérisé en ce que**
la zone de rayonnement optiquement transparente (OB ; OB') et la zone de montage périphérique (RB ; RB') sont prévues sur la quatrième surface (04) de la deuxième puce (1b).

4. Dispositif de détection optique selon la revendication 2 ou 3,
**caractérisé en ce que**
la zone de réception de puce (DP ; DP') présente une cinquième et une sixième surfaces opposées (05, 06) et la cinquième surface (05) est reliée à une zone de montage (RB).

5. Dispositif de détection optique selon la revendication 4,
**caractérisé en ce que**
la deuxième surface (06) n'est pas recouverte par le dispositif d'emballage (MV, MV") et se trouve dans le même plan qu'une face inférieure (US) du dispositif d'emballage (MV, MV'').

6. Dispositif de détection optique selon la revendication 5,
**caractérisé en ce que**
les éléments de connexion (AB, AB") dépassent de surfaces latérales opposées (SSW1, SS2) du dispositif d'emballage (MV, MV") et leurs extrémités se trouvent dans le plan de la face inférieure (US).

7. Dispositif de détection optique selon la revendication 6,
**caractérisé en ce que**
les extrémités des éléments de connexion (AB, AB'' et en option la sixième surface (06) sont reliées à un substrat (SUB, SUB") qui présente un trou débouchant (DL-DL"') dans la zone de la fenêtre (F ; F').

8. Dispositif de détection optique selon la revendication 4,
**caractérisé en ce que**
la sixième surface (06) est partiellement recouverte par le dispositif d'emballage (MV, MV") et une face inférieure (US') du dispositif d'emballage (MV, MV") se trouve dans un plan en dessous de la face inférieure (US').

9. Dispositif de détection optique selon la revendication 8,
**caractérisé en ce que**
les éléments de connexion (AB, AB") dépassent au niveau de surfaces latérales opposées (SSW1, SS2) du dispositif d'emballage (MV, MV") et leurs extrémités se trouvent dans le plan de la face inférieure (US').

10. Dispositif de détection optique selon la revendication 9,
**caractérisé en ce que**
les extrémités des éléments de connexion (AB, AB") sont reliées à un substrat (SUB, SUB") qui présente un trou débouchant (DL-DL") dans la zone de la fenêtre (F ; F').

11. Dispositif de détection optique selon l'une des revendications 7 ou 10,
**caractérisé en ce que**
sur la deuxième ou la quatrième surface (02, 04) de la première puce (1a) et/ou au niveau du substrat (SUB, SUB") dans la zone du trou débouchant (DL-DL"), on prévoit un dispositif de filtration optique (FS ; FI ; FI").

12. Dispositif de détection optique selon l'une des revendications précédentes,
**caractérisé en ce que**
le cadre de montage (MLF ; MLF') est un cadre soudé.

13. Dispositif de détection optique selon l'une des revendications 3 à 12,
**caractérisé en ce que**
la zone de liaison câblée (BB) dépasse latéralement de la zone de réception de puce (DP').

14. Procédé de fabrication d'un dispositif de détection optique selon l'une des revendications précédentes,
**caractérisé par**
les étapes suivantes:
liaison du dispositif de puce de détection (10 ; 10') dans la zone de montage (RB ; RB') avec la zone de réception de puce (DP ; DP'), et dans la zone de liaison par fil (BB) avec un ou plusieurs éléments de connexion (AB-AB") ; et
mise en place du dispositif d'emballage (MV-MV''') dans un processus de moulage.
